# EUROPEAN PATENT SPECIFICATION

(11) **EP 0 226 445 B1**
(45) Date of publication and mention of the grant of the patent: **20.10.1993**
(21) Application number: 86309597.2
(22) Date of filing: 10.12.1986
(51) Int. Cl.: H01S 3/25, G06K 15/12

(54) **Laser array**
Vielfachanordnung von Lasern
Réseau de lasers

(30) Priority: 12.12.1985 US 808197
(43) Date of publication of application: 24.06.1987
(60) Divisional application: 92203738.7
(73) Proprietor: XEROX CORPORATION, Rochester New York 14644 (US)
(72) Inventor: Thornton, Robert L., East Palo Alto California 94303 (US); Sang, Henry W., Jr., Santa Clara California 95051 (US); Paoli, Thomas L., Los Altos California 94022 (US); Burnham, Robert D., Palo Alto California 94306 (US)
(74) Representative: Weatherald, Keith Baynes

(56) References cited:
- US-A- 4 445 125
- US-A- 4 479 221
- APPLIED PHYSICS LETTERS, vol. 47, no. 5, 1st September 1985, pages 450-452, American Institute of Physics, Woodbury, New York, US; T.L. PAOLI et al.: "High-power multiple-emitter AlGaAs superluminescent diodes"
- APPLIED PHYSICS LETTERS, vol. 46, no. 5, 1st March 1985, pages 465-467, American Institute of Physics, Woodbury, New York, US; H. TEMKIN et al.: "Index-guided arrays of Schottky barrier confined lasers"
- IBM TECHNICAL DISCLOSURE BULLETIN, vol. 16, no. 4, September 1973, page 1186, New York, US; W.P. DUMKE: "Simple planar double-heterojunction laser structure"
- APPLIED PHYSICS LETTERS, vol. 46, no. 9, 1st May 1985, pages 857-859, American Institute of Physics, Woodbury, New York, US; P. GAVRILOVIC et al.: "Impurity-disordered, coupled-stripe AlxGa1-xAs-GaAs quantum well laser"
- LASER FOCUS, vol. 19, no. 10, October 1983, pages 101-109, Newton, Massachusetts, US; R.A. SPRAGUE et al.: "Advances in laser and E-O printing technology"
- APPLIED PHYSICS LETTERS, vol. 42, no. 11, 1st June 1983, pages 934-936, American Institute of Physics, Woodbury, New York, US; H. TEMKIN et al.: "Integrated arrays of 1.3-mum buried-crescent lasers"

## Description

This invention relates to incoherent non-phase-locked laser arrays and in particular non-phase-locked or optically-uncoupled laser arrays having a broad uniform far field with high intensity which are highly adaptable for use as illuminating sources with electro-optic line modulators and electro-optic line printers.

In the prior art, semiconductor lasers and light-emitting diodes (LEDs) have been employed as a light source to produce an image on a photosensitive medium such as a xerographic photoreceptor used in a xerographic printer. In this kind of application, there is a need for uniformity of the intensity of light in the image as well as sufficient intensity of the light emitted. Further, if LEDs have to be utilized, it is necessary to provide a full width array of LEDs, one per picture element or pixel so that a line of light can be formed for discharge of the photoreceptor in an imagewise manner. Usually a plurality of light-emitting device arrays are arranged in one or more rows, and optical means is positioned between the photosensitive medium and the light source array to focus the light from the array sources to a single line on the surface of the photosensitive medium. The light sources are selectively turned on and off to effect line-by-line exposure of the moving photosensitive medium.

Semiconductor lasers have also been used in the past as such light sources for rotary prism scanned printers because of their high intensity in a focussed spot. They have not, however, been totally best suited for application in electro-optic line printers because of inadequate power and inadequate uniformity of light intensity. In particular, high-power coherent laser sources possess a far field pattern containing regions of high intensity and of low intensity in the single beam far field, i. e., the far field pattern is not uniform. Such a variation in intensity across the beam output is not desired because the line exposure on the photosensitive medium will not be uniform. For this and other reasons, LEDs have been more favored as a light source for electro-optic line printers because they may be designed to provide a light output of monotonically varying intensity with very short coherence length.

In some cases, LEDs in the past have not provided sufficient output power and intensity to accomplish in an efficient manner the task of exposing a charged and moving photosensitive medium. In addition, an LED is much less efficient than a laser. For this reason, LEDs as light sources for xerographic photoreceptor applications have lacked the output intensity level for good photoreceptor discharge and as a result, semiconductor lasers have been still favored in many cases as the light source for printer applications.

Beside the problem of sufficiency of LED intensity, the maintenance of light output uniformity among a plurality of LEDs, as well as a multiple laser source, as alluded to above, is a recognized problem in the art. To ensure that the intensity of the broad light emission from the array is uniform across an LED array, elaborate control systems have been designed to provide for light intensity uniformity, as exemplified, for example, in US-A-4,455,562. This patent utilizes a binary-weighted duty cycle control to obtain substantial uniformity in the light emitted from each LED in the array of LEDs.

The highest power LEDs have been top emitter types, but they lack the power density necessary for most printer applications, i.e., they lack sufficient light density per aperture size.

A most recent advancement in the printer art has been the concept of a total internal reflection (TIR) line modulator, which is a solid state multigate light valve which may be used to address a photosensitive medium. The line TIR modulator comprises a crystal bar of electro-optic material with an array of interdigital electrodes deposited on one of its major surfaces, which electrodes, when electrically addressed, introduce or induce a periodic electric field into the bulk crystal. Each of the electrodes may be individually addressed by an electronic signal to form a signal pattern across the array. A broad or wide sheet-like beam of high intensity light is required for the line modulator. The beam is introduced into the crystal at an angle incident to the plane of the major surface incorporating the electrodes. An example of the line TIR modulator is disclosed in US-A-4,281,904.

To carry out the exposure process of the photosensitive medium, a sheet-like beam of light is transmitted through the electro-optic element of the TIR line modulation at a slight angle relative to the optical axis of the light, to cause total internal reflection at the internal surface incorporating the electrode array. Successive sets of digital bits or analog samples, representing respective collections of picture elements or pixels for successive lines of an image, are sequentially applied to the electrode array. Localized electric bulk or fringe fields developed in the crystal in proximity to the TIR incidence of light modulate the light and change the phase front of the sheet-like light beam in imagewise configuration on to the charged photosensitive medium. Examples and teachings relative to electro-optic line printer applications may be found in US-A-4,367,925; 4,369,457; 4,370,029; 4,437,106; 4,450,459; 4,480,899 and 4,483,596.

More recently, a super-luminescent LED side-facet source has been developed for electro-optic line modulation and line printers which is characterized by having high output intensity and a uniform far field emission and optical means to collimate the far field emission in the tangential direction and focus the near field in the sagittal direction onto the modulator. The optical means comprises a first lens system to collect the light emitted from the LED source in both the tangential and sagittal directions and a second toric lens to collimate the light into a sheetlike beam in the tangential direction and to focus the light in the sagittal direction to a line image at the modulator. Imaging means is optically aligned between the modulator and the record medium for imaging the modulator on to the record medium of a line printer.

Such an LED has nearly ideal characteristics as an optical source in printing applications utilizing multigate or electro-optic modulators because its radiation pattern is broad and varies monotonically in a predictable way without the sharp or irregular structure encountered with a diode laser array. In addition,, the optical spectrum of the LED is sufficiently broad that optical interference effects are negligible. However, an LED inherently has a lower overall efficiency, e.g. conversion efficiency, than a diode laser since LED light is emitted in many different directions and also this requires that the LED of comparable output power operates at higher temperatures and higher input power than the diode laser source.

Thus, an optical source with the incoherence of an LED but the efficiency of a diode laser is desirable for line modulator and printer applications.

Accordingly this invention provides an incoherent diode laser array as claimed in the appended claim 1. Claim 3 is related to the use of such a laser array in an electro-optic line printer.

In order to produce an array of closely-spaced lasers on a single chip which operate in an optically uncoupled manner, it is necessary to reduce the strength of the evanescent field extending from each laser cavity to adjacent laser cavities below a level required for accomplishing stable phase-locking. This decoupling may be accomplished in several ways, First, for example, in a laser array of conventional gain-guided lasers, the individual laser elements must be separated by a relatively large distance, e. g., on the order of 50 µm or more, in order to achieve uncoupled operation. However, separation of the laser elements in the array by such a large distance leads to reduced efficiency because of the substantial amount of wasted current spread away from the active regions of the individual laser elements and the inability to collect the light in the far field efficiently for particular applications, such as electro-optic modulators and line printers. In addition, for large separations, the far field of the total array becomes nonuniform because of the decreased overlap of the far field patterns of the individual laser emitters, which would render this type of structure unsuitable for electrooptic line printers. In the case of an array of index-guided lasers, the matter of far field separation would be better satisfied, since the individual laser emitters need not be separated as far because of the tighter optical field confinement provided by the individual lasers of such an array. For both index-guided and gain-guided laser arrays, optical absorption can be introduced between the lasers in order to eliminate the leakage of light from one laser into an adjacent laser waveguide or cavity at the cost of increased threshold and decreased efficiency. A closely-spaced uncoupled array without optical absorption is the most desirable situation.

The present invention provides the necessary close spacing of the laser emitters of the array while sustaining uncoupled lasing operation by by forming regions of isolation between the laser cavities of the array using impurity-induced disordering (IID). The desired end is to isolate the optical cavities of the individual cavities of the lasers so that there will be no optical coupling between them.

The present invention will now be described by way of example, with reference to the accompanying drawings, in which:
Figure 1 is a schematic side view of an electro-optic line printer to carry out the present invention;
Figure 2 is a plan view of the line printer shown in Figure 1;
Figure 3 is an enlarged side view of a TIR multigate line modulator;
Figure 4 is an enlarged bottom view of the modulator shown in Figure 3 to illustrate the individually addressable electrodes of the modulator;
Figure 5 is a schematic illustration of an incoherent laser array for use with the printer shown in Figure 1;
Figure 6 is a graphic illustration of the pulsed and CW power versus current characteristics for the laser array shown in Figure 6, with the inset illustrating the near field profile at 100 mA drive current, and
Figure 7 is a graphic illustration of the far field emission characteristics for the laser array shown in Figure 6.

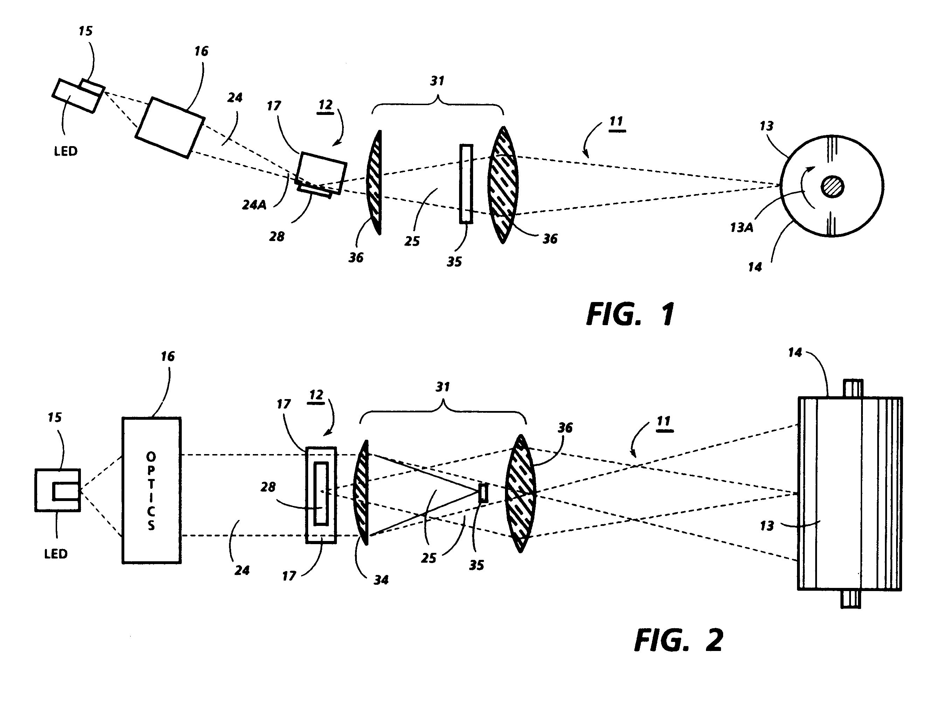

In Figures 1 and 2, there is shown an electro-optic line printer 11 having a fringe field responsive multigate light valve or TIR line modulator 12 for printing an image on a photosensitive record medium 13. As shown, the record medium 13 is a photoconductively coated drum 14 which is rotated (by means not shown) in the direction indicated by arrow 13A. Other xerographic and non-xerographic record media could be used, including photoconductively coated belts and plates, as well as photosensitive films and coated papers. Thus, in the generalized case, the record medium 13 should be visualized as being a photosensitive medium which is exposed while advancing in a cross-line or line-pitch direction relative to modulator 12.

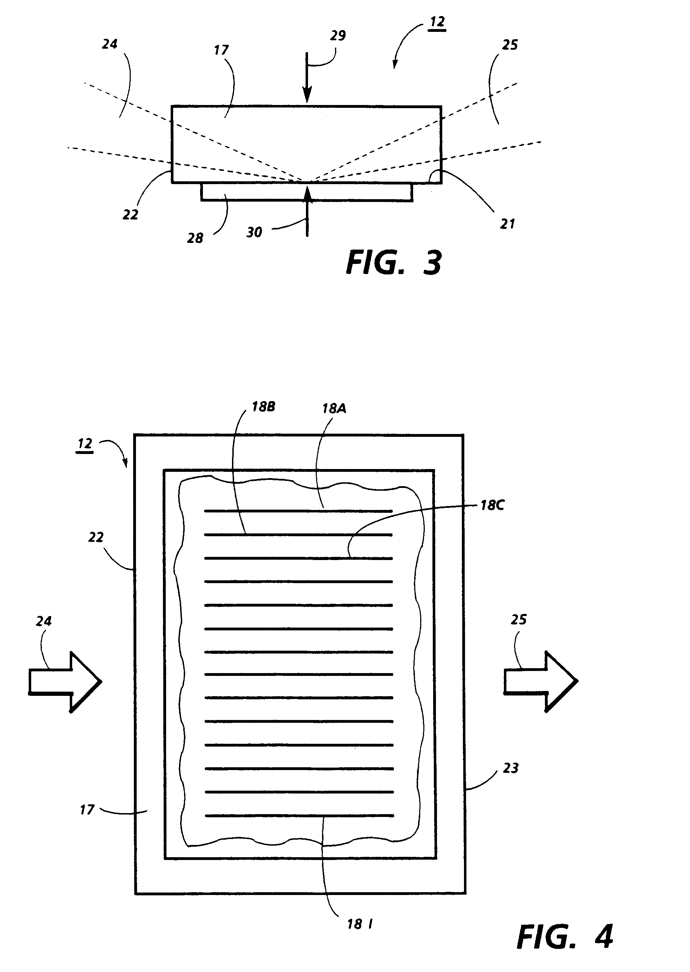

As best illustrated in Figures 3 and 4, modulator 12 comprises an optically transparent electro-optic element 17 and a plurality of individually addressable electrodes 18A-18I. The most promising electro-optic materials for such a device presently appear to be LiNbO₃ and LiTaO₃, but there are others which warrant consideration, including DSN, KDP, Kd^{x}P, Ba₂NaNb₅O₁₅ and PLZT. In this particular embodiment, modulator 12 is operated in a TIR mode. Thus electro-optic element 17 is suitably a y-cut crystal of, say LiNbO₃ having an optically polished reflecting surface 21 extending between opposed, optically-polished, input and output faces 22 and 23, respectively. Typically, each of the electrodes 18A-18I is 1 to 30 µm wide, and the interelectrode gap spacing is 1 to 30 µm.

Referring to Figures 1 through 4 for a brief review of the operation of modulator 12, it will be seen that a sheetlike collimated light beam 24 from an incoherent laser array light source 15 is transmitted, via front end optics 16, through input face 22 of electro-optic element 17 at a grazing angle of incidence relative to reflecting surface 21, i.e., at an angle no greater than the critical angle of incidence for total internal reflectance from that surface.

The input beam 24 is laterally expanded by optics so that it more or less uniformly illuminates substantially the full width of the electro-optic element 17 and is brought to a wedge shaped focus 24A by optics 16 on the reflecting surface 21 approximately midway through electro-optic element 17. Accordingly, input beam 24 is totally internally reflected from reflecting surface 21 to provide an output beam 25 which exits from the electro-optic element 17 through its output face 23.

The phase front or the polarization of output beam 25 is spatially modulated in accordance with the data applied to electrodes 18A-18I. More particularly, if the data create a voltage drop between any adjacent pair of electrodes, such as electrodes 18B and 18C, a corresponding fringe field is coupled into electro-optic element 17, thereby producing a localized variation in its refractive index. To couple such fringe fields efficiently into electro-optic element 17, electrodes 18A-18I are supported on or very near reflecting surface 21 thereof. Electrodes 18A-18I preferably are deposited on a suitable substrate, such as a VLSI silicon circuit 28, which is pressed or otherwise firmly held against electro-optic element 17, as indicated by the arrows 29 and 30, to maintain electrodes 18A- 18I in contact with, or at least closely adjacent, reflecting surface 21. The advantage of this construction is that VLSI circuit 28 may be used to make the necessary electrical connections to electrodes 18A-18I. Alternatively, electrodes 18A-18I could be deposited on reflecting surface 21 of electro-optic element 17.

For illustrative purposes, it has been assumed that the phase front of the output beam 25 is spatially modulated in accordance with the data applied to electrodes 18A-18I. Accordingly, Schlieren central dark field or bright field imaging optics are used to convert the phase front modulation of the output beam 25 into a correspondingly modulated intensity profile and to supply any magnification that may be needed to obtain an image of the desired size at the surface of record medium 13. More particularly, as shown, there is a central dark field imaging optics 31 comprising a field lens 34, a central stop 35, and an imaging lens 36. The field lens 34 is optically aligned between output face 23 of electro-optic element 17 and stop 35 to focus substantially all of the zero-order diffraction components of the output beam 25 onto stop 35. However, the higher-order diffraction components of output beam 25 scatter around stop 35 and are collected by imaging lens 36 which, in turn, focuses these components onto record medium 13 to provide an intensity-modulated image of modulator 12.

Referring again to Figure 4, it will be noted that each of the electrodes 18A-18I is individually addressable. Therefore, to print an image, differentially encoded data samples for successive lines of the image are sequentially applied to electrodes 18A-18I. As a matter of definition, each differentially encoded data sample, other than the first sample for each line of the image, has a magnitude which differs from the magnitude of the previous differentially encoded sample by an amount corresponding to the magnitude of a particular input data sample. The first differentially encoded sample for each line is referenced to a predetermined potential, such as ground. Thus, when the differentially encoded data samples for any given line of the image are applied to electrodes 18A-18I, the picture elements for that line are faithfully represented by the electrode-to-electrode voltage drops at modulator 12.

To supply the differentially encoded data samples, serial input data samples representing adjacent picture elements or pixels for successive lines of an image are applied to a differential encoder at a predetermined data rate. The encoder differentially encodes these input samples on a line-by-line basis, and a multiplexor ripples the encoded data samples onto electrodes 18A-18I at a ripple rate which is matched to the data rate. The input data may be buffered to match the input data rate to any desired ripple rate.

Alternatively, a set of ground plane electrodes (i.e., not shown, but being electrodes referenced to the same voltage level as the raw input data samples) may be interleaved with the individually addressable electrodes, thereby avoiding the need for differential encoding. As a general rule, however, the advantages of reducing the number of electrodes required to achieve a given resolution justify the additional circuitry needed for differential encoding.

For printer 11 in the sagittal direction, optics 16 images the near field light from laser array source, which may, for example, be one quarter to one µm wide spot, onto modulator 12. This spot image is imaged down to be one diffraction-limited spot wide in modulator 12. The output 25 from modulator 12 is then broadened out, for example, to a 10 µm spot for a one µm source spot. In the tangential direction, the light is collimated by the optics 16 at modulator 12 so that it is illuminated with the far field of laser array source 15.

Thus, each adjacent pair of electrodes, such as the electrodes 18B and 18C shown in Figure 4, cooperate with electro-optic element 17 and readout optics 31 to define effectively a local modulator for creating a picture element or pixel at a unique, spatially-predetermined, position along each line of an image to be replicated at medium 13.

Reference is now made to the type of laser array desirable for utilization with line printer 11. In general, the emitters of the laser array must not be phase-locked but have to be sufficiently closely spaced for the far field pattern to be a uniform emission pattern of Gaussian form, which emitter composite pattern corresponds to the far field emission pattern of the individual laser emitters or laser elements of the array. In other words, the spatial criteria for the emitters are that they must be spatially close enough to form a uniform far field pattern but at the same time not provide phase locking between adjacent emitters. This is a difficult situation because, as the prior art shows, phase-locking occurs when the spacing of emitters is close, but if the emitter separation is increased to an extent to eliminate stable phase-locking, the far field emission pattern will not be uniform because of the large distance between emitters, and there will remain far field lobes and irregularities preventing uniformity across the far field pattern.

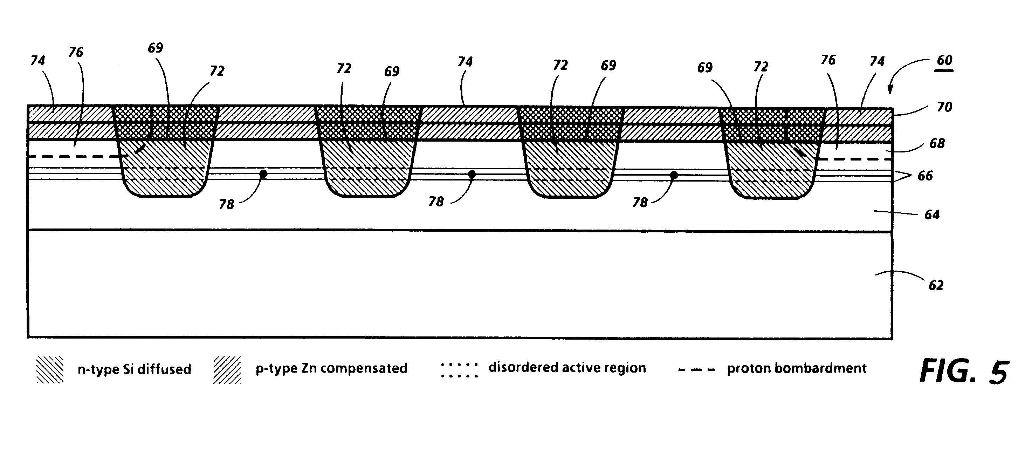

Thus, it is necessary to introduce some mechanism or means by which the emitters may be sufficiently closely spaced but not phase-locked, i.e., remain incoherent relative to one another and the net optical intensity in the far field is the added effect of the optical intensities of the individual emitters. The mechanism or means may be in the form of either lateral displacement of the emitters in their geometry, or isolation imposed between the individual emitters for an index-guided laser array structure. An example of optical isolation is illustrated in Figure 5.

Figure 5 illustrates incoherent laser array 60 having a plurality of closely-spaced laser elements formed with impurity-induced disordering (IID). Only three laser emitters 78 are shown for the sake of expediency and simplicity, but obviously there may be multiple emitters formed.

Laser array 60 comprises n-GaAs substrate 62 upon which are epitaxially deposited the following layers: cladding layer 64 of n-Ga₁₋ₓAlₓAs, where x may, for example, be equal to 0.4 and the layer may be about 1.5µm thick; active region 66 comprising an active layer or a single quantum well structure or a multiple quantum well structure, for example, GaAs four quantum well layers each 10 nm thick separated by barrier Ga_{0.65}Al_{0.35}As layers each 7 nm thick; cladding layer 68 of p-Ga₁₋ₓAlₓAs, where x may, for example, be equal to 0.4 and the layer may be about 0.8 µm thick; and cap layer of p⁺-GaAs being about 0.1 µm thick. The active region may be p doped, n doped or undoped.

In order to form the IID n-type regions 72 shown in Figure 5, an array of diffusion windows is patterned into a Si₃N₄ film deposited on cap layer 72, followed by the deposition of a silicon film to serve as the source of silicon for the diffusion process. The processing of laser array 60 begins with the deposition of a film of Si₃N₄ of about 100 nm thick. This film is photolithographically patterned to provide windows or openings for forming regions 72 via Si diffusion. Next, an approximately 50 nm thick film of silicon is deposited on the array, followed by another film of Si₃N₄ of approximately 100 nm thickness. Diffusion is performed at 850°C for 7.5 hours to disorder the active region in areas adjacent to what will eventually become the lasing filaments, as represented by emitters 78.

The n-type Si diffusion regions are shown as cross-hatched regions 72 extending through active region 66. It is preferred that the diffusion extends through the active layer and any layers that form a part of or function as part of the optical cavity of each laser element. In this regard, the diffusion may extend partly into lower cladding layer 64 depending, for example, upon the percentage of aluminium in the inner cladding layer. If additional inner confinement layers are provided with the active region, it is preferred that the diffusion extend through such confinement layers since they are part of the laser element optical cavity. The result to be realized is that the diffusion must extend sufficiently through the optical cavity of each laser element to prevent stable phase-locking between adjacent emitters because of overlap of the evanescent optical wave extending between adjacent cavities. The diffusion regions 72 provide both optical confinement of this wave as well as carrier confinement to the individual laser cavities represented by the emitters 78 so that the individual laser elements may be closely spaced, such as on 4-10 µm centers, without being optically coupled to one another.

After the diffusion, the Si layer and both Si₃N₄ layers are removed by etching in a CF₄ plasma. The entire surface of array 60 is then Zn-diffused, as indicated by the cross-hatched area 74, to reconvert the n-type Si-diffused GaAs cap layer 70 and part of cladding layer 68 to p-type material. It is important that the Zn diffusion penetrate into cladding layer 68, because of the properties of the resulting parasitic p-n junction 69 that is in parallel with the active region lasing junction. As a result of the Zn diffusion, this parasitic junction 69 lies in a high aluminum cladding layer 68, which junction has a much higher turn-on voltage than that of the GaAs active region 66. Since the bandgap of the material at junction 69 is significantly higher than at the active region GaAs junction, this junction conducts significantly less current at a given junction voltage than the lasing junction in the active region. Therefore, the leakage current through the high aluminum junction 69 is only a very small fraction of the total current through the array device, and does not significantly degrade device performance.

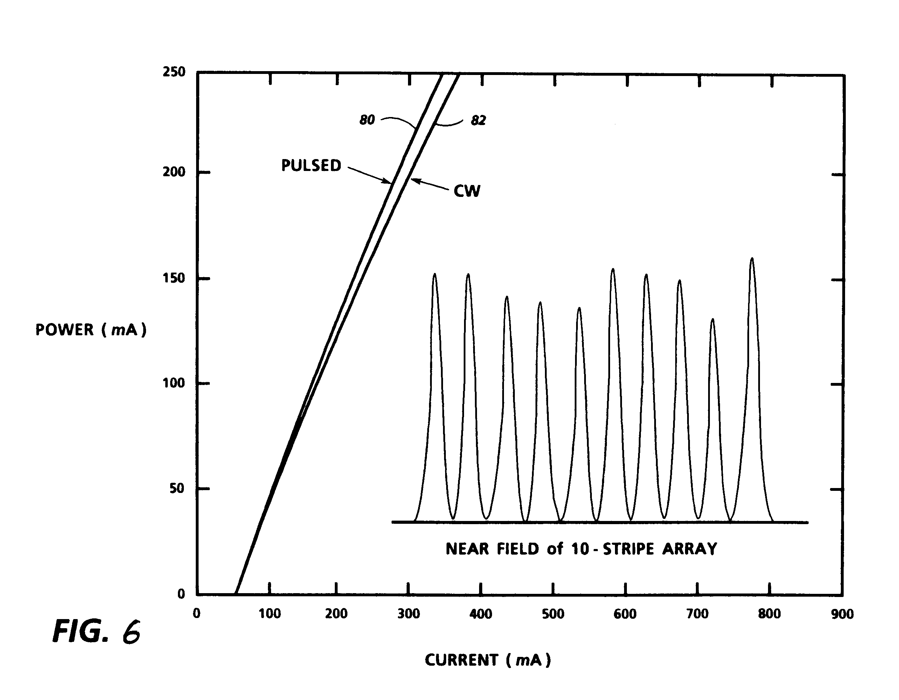

Finally, a relatively broad mask is aligned to cover a little more than midway of the outer two diffusion regions 72 of the device and a proton bombardment isolation is performed on the outlying regions of the array 60. This isolation is represented by the dotted lines in Figure 6 forming isolation regions 76. The purpose of this implant is to prevent current flow in the outlying regions 76 that have not been previously disordered by the silicon diffusion. To accomplish this, the implant need only fall somewhere within the outer Si disordered regions and the alignment of the implant mask is not, therefore, critical.

After proton implantion at an energy of 70 keV with a dose of 3 x 10¹⁵, laser array 60 is metallized with Cr-Au or Ti-Pt-Au on cap layer 70 and alloyed with Au-Ge, followed by Cr-Au or Ti-Pt-Au on the bottom surface of substrate 62.

A λ/2 Al₂O₃ layer may be deposited on the front facet of laser array 60 for passivation. A six-layer multilayer stack of Al₂O₃-Si λ/4 layer-pairs may be deposited on the rear facet to increase its reflectivity to approximately 95% and thereby reduce the lasing threshold of the device by approximately 20-30%.

It has been demonstrated in the past that several different diffused species may produce the IID effect. For example, disordering is possible also with Zn, Ge, Sn and S. Also, disordering is possible through implantation of elements acting as shallow or deep level impurities, such as Se, Mg, Sn, O, S, Be, Te, Sl, Mn, Zn, Cd, Ln, Cr or Kr, followed by a high temperature anneal best performed in an As environment.

For laser devices, disordering by both zinc and silicon via their diffusion have been successfully accomplished and there has been considerable interest in the lower thresholds ultimately attainable in these devices. Since devices utilizing IID have very strong lateral confinement of carriers, the threshold currents are limited primarily by the width of the laser contact stripes that one is able to achieve in the photolithographic process and maintain in the diffusion process. In previously fabricated IID laser structures, device geometry required that the contact mask be aligned to a dimension smaller than the width of the lasing filament, while avoiding contacting the diffused region adjacent to the active region. Therefore, if a very narrow lasing filament for each laser emitter is desired, e.g. 2 µm width, the width of the lasing stripe becomes limited by the minimum diffusion window opening width achievable and the associated alignment tolerance. This problem is further compounded when it is desired to make a multiple emitter laser array of the type desired herein, where it is highly desirable to have the emitters closely spaced without establishing phase locking. However, a novel feature of laser array 60 is the concept of completely submerging the n-type diffusion with the p-type compensation across the entire width of the array device, allowing a single broad area surface contact to be used to pump the entire array. Using this technique, it is possible to reduce the emitter width successfully to about 2 µm or less with 6µm spacing, resulting, for example, in the fabrication of a ten-emitter laser array 60 with a current threshold of about 53 mA and with a power output of up to 250 mW CW or more.

It can be seen, then, that close spacing of lasing elements of the array can be achieved without phase-locking or optical coupling to form a broad uniform far field pattern best suited for electro-optic line modulators and printers and also providing low operating current thresholds and with accompanying lower heat generation compared with LED super-luminescent devices of comparable output power.
The advantages of the incoherent laser array of this invention compared with the super-luminescent LED are several: First, there are no extra lobes appearing in the far field pattern. Secondly, there is reduced speckle pattern in the far field, because without optical coupling there is an additive effect of the different speckle patterns of the individual laser elements of the array so that their combined effect in the far field is a high level of uniform intensity in the far field pattern. Third, the current threshold at about 50 mA clearly demonstrates the significant reduction of heating problems. Fourth, the laser array has higher efficiency than the super-luminescent LED of about 20-40% or more. Fifth, the laser array, because of its lower current/temperature operating characteristics, provides a wide range of power availability for various light source input requirements of different types of electro-optic line modulators and line printers.

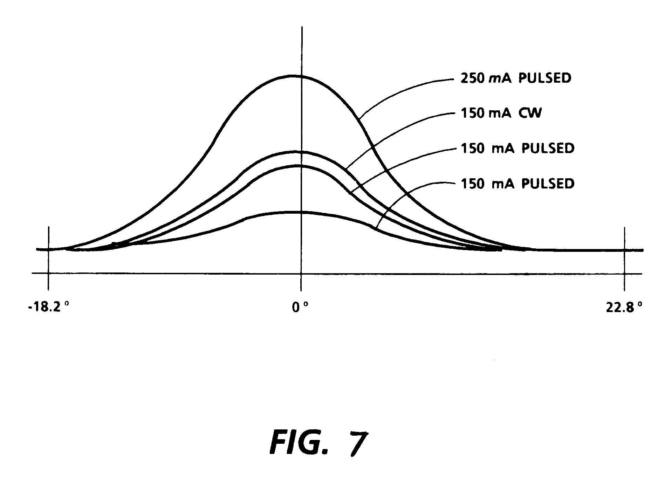

Figures 6 and 7 illustrate the power versus current output characteristics, and the near field and far field patterns of a multiple emitter laser array 60 having the multiple quantum well structure as previously described relative to Figure 5 and provided with 2 µm wide emitters 78 with spacing between the emitters being 6 µm. The lasing threshold for this array is 53 mA. The pulsed power versus current curve 80 in Figure 6 gives a differential quantum efficiency of 62%. With a measured series resistance of 1.3 Ω, the total power conversion efficiency at 250 mW is 43%. These high efficiency numbers provide evidence that the lasing filaments waveguides have relatively little loss introduced by the Si diffusion process. Also, it is clear from the near field pattern in the inset of Figure 6 that the lateral optical confinement is strong, as evidenced by the fact that the emitters have clearly-resolved nulls separating them. Also to be noted is the high degree of uniformity between the ten individual emitters comprising the array.

In Figure 7, the uniform broad far field patterns for 100, 150 and 250 mA pulsed operation and 150 mA CW operation show that there remains incoherent operation among the separate emitters for increasing applied input without phase locking, as illustrated by the aligned Gaussian profiles. The emitters 78 are closely spaced to within 6 µm without exhibiting any phase-locked condition under different applied currents.

Other alloy systems may be used to fabricate the laser arrays utilized herein with visible emission wavelengths, e.g., InGaP/InGaAsP/InGaP or AlGaInP/InGaP/AlGaInP.

Also, the doping type of the laser array layers may be obviously reversed with p-type IID regions 72. Further, transparent window may be formed at the output facet of the laser array by thermally annealing the quantum well active region over a small region near the laser output facet in order to shift its absorption to a higher energy.

## Claims

1. An incoherent, optically-uncoupled semiconductor laser array (60) comprising a layer of active material (66) sandwiched between two layers of cladding material (64, 68), the active layer having embodied within it a plurality of spatially-separated laser emitters (78), each emitter being optically isolated from the or each adjacent emitter by an optical isolation region providing index-guiding and preventing the evanescent optical field of each emitter from overlapping into the optical fields of the or each adjacent emitter, thereby preventing phase-locking between them, in order to provide high-power density and uniform far-field pattern,
characterised in that
the optical isolation regions are impurity-disordered regions (72) extending through the active layer.

2. The laser array as claimed in claim 1, in which each optical isolation region (72) extends across the width of the laser array and into the laser array for a distance sufficient to isolate the adjacent emitters optically from one another.

3. Use of a laser array as claimed in any preceding claim, as illuminating source in an electro optic line printer (11).

## Patentansprüche

1. Inkohärente, optisch entkoppelte Halbleiterlaser-Anordnung (60) umfassend eine Schicht aus Aktivmaterial (66), die zwischen zwei Schichten aus Plattierungsmaterial (64, 68) geschichtet ist, wobei die Aktivschicht in sich eine Mehrzahl von räumlich getrennten Laseremittern (78) einschließt, wobei jeder Emitter von dem oder jedem benachbarten Emitter durch einen optischen Isolationsbereich isoliert ist, der eine Indexführung bereitstellt und verhindert, daß das schwindende optische Feld jedes Emitters in die optischen Felder des oder jedes benachbarten Emitters übergreift, wodurch eine Phasenverriegelung zwischen ihnen verhindert wird, um eine hohe Leistungsdichte und ein gleichmäßiges Fernfeldmuster bereitzustellen,
***dadurch gekennzeichnet,*** daß
die optischen Isolationsbereiche fremdatomgestörte Bereiche (72) sind, die durch die Aktivschicht verlaufen.

2. Laseranordnung nach Anspruch 1, bei der jeder optische Isolationsbereich (72) sich über die Breite der Laseranordnung und in die Laseranordnung für eine Strecke ausdehnt, die ausreichend ist, um die benachbarten Emitter optisch voneinander zu isolieren.

3. Verwendung einer Laseranordnung nach einem der vorangehenden Ansprüche als Beleuchtungsquelle in einem Zeilendrucker (11).

## Revendications

1. Réseau de lasers à semi-conducteurs incohérent découplés optiquement (60) comprenant une couche d'un matériau actif (66) placée entre deux couches d'un matériau de guidage (64, 68), la couche active ayant incorporés dans celle-ci une multitude d'émetteurs lasers spatialement séparés (78), chaque émetteur étant optiquement isolé de chaque émetteur contigu par une région d'isolement optique procurant un guidage d'indice et empêchant le champ optique évanescent dans chaque émetteur de se chevaucher dans le champ optique de l'émetteur contigu ou de chaque émetteur contigu, empêchant de ce fait le verrouillage de phase entre ceux-ci, afin de procurer une densité de puissance élevée et un diagramme de champ lointain uniforme,
caractérisé en ce que
les régions d'isolement optique sont des régions désordonnées par impuretés (72) s'étendant sur toute la couche active.

2. Réseau de lasers selon la revendication 1, dans lequel chaque région d'isolement optique (72) s'étend à travers la largeur du réseau de lasers et dans le réseau de lasers sur une distance suffisante pour isoler optiquement les émetteurs contigus l'un de l'autre.

3. Utilisation de réseau de lasers selon l'une quelconque des revendications précédentes, comme source d'éclairement dans une imprimante électro-optique ligne par ligne (11).
